Europäisches Patentamt

European Patent Office

Office européen des brevets

(11) Publication number: **0 496 169 A1**

## EUROPEAN PATENT APPLICATION

(21) Application number: **91312025.9**

(22) Date of filing: **24.12.91**

(51) Int. Cl.5: **H01L 21/90**, H01L 21/60

(30) Priority: **25.01.91 US 609954**

(43) Date of publication of application:
**29.07.92 Bulletin 92/31**

(84) Designated Contracting States:
**DE FR GB IT**

(71) Applicant: **AMERICAN TELEPHONE AND TELEGRAPH COMPANY**
**550 Madison Avenue**
**New York, NY 10022(US)**

(72) Inventor: **Wong, Yiu Man**
**5001 Maranatha Way**
**Wescosville, Pennsylvania 18106(US)**
Inventor: **Yu, Chen-Hua Douglas**
**1019 Hillview Drive**
**Allentown, Pennsylvania 18103(US)**

(74) Representative: **Johnston, Kenneth Graham et al**
**AT&T (UK) LTD. AT&T Intellectual Property Division 5 Mornington Road**
**Woodford Green Essex, IG8 OTU(GB)**

(54) **Method of integrated circuit fabrication including filling windows with conducting material.**

(57) Metal filled openings in a patterned dielectric (3) form a planar surface with the dielectric through the use of a sacrificial layer (7) which is deposited prior to the metal deposition (11) and is then removed after metal deposition to leave a planar surface.

FIG. 2

## Technical Field

This invention relates to a method of integrated circuit fabrication which involves the step of filling openings in patterned layers.

## Background of the Invention

In many semiconductor integrated circuit fabrication sequences, a dielectric layer is patterned to form openings, such as windows, which expose selected portions of the underlying material, i.e., the substrate. The windows are then filled with a conducting material, such as aluminum, so that the underlying material may be electrically contacted from the top surface of the dielectric. The process described is conceptually simple and has been successfully implemented. For a variety of reasons, its successful implementation with aluminum in windows at micron and submicron lateral dimensions is difficult, i.e., the windows may not he completely filled.

Aluminum is presently the most widely used metal in semiconductor integrated circuits and is typically deposited by sputtering. However, it is difficult to sputter successfully at submicron dimensions because of possible shadowing effects unless, for example, the window is tapered. One approach to eliminating the problem of filling the window, without tapering, is to change to metals that do not form re-entrant angles. However, deposition techniques may also have to be changed if other metals are used.

However, aluminum has desirable electrical characteristics, and its use in integrated circuits is frequently advantageous. Alternatives to deposition by simple sputtering have therefore been sought. One such approach was described by *Bai et al. in the Proceeding of the V-MIC Conference, pp. 382-389, June 13-14, 1988*. The approach used a partially ionized aluminum beam. The substrate was at an elevated temperature to enhance surface mobility of the aluminum ions so that complete filling of the windows was possible. The deposition was very directional and therefore nonconformal. After the window was filled, deposition was continued as the temperature was increased, and the authors stated that a planarized aluminum deposition was obtained.

Another technique deposits a resist on a dielectric and then patterns the resist and the underlying dielectric. A metal is blanket deposited at an elevated temperature and a lift-off step performed to remove the metal deposited directly on the resist. In practice, this method is undesirable because the elevated temperature required frequently causes unwanted chemical reactions at the resist-substrate interface resulting in a residue of resist film.

## Summary of the Invention

A method of semiconductor integrated circuit manufacturing forms openings in a dielectric layer which expose selected portions of the underlying substrate and fills the openings with a metal, e.g., aluminum. The opening is formed by depositing a sacrificial dielectric layer prior to patterning and then patterning both the sacrificial dielectric layer and the dielectric layer. The sacrificial dielectric layer should have a re-entrant angle, i.e., the lateral dimension at the bottom of the sacrificial layer is greater than the lateral dimension at the top of the sacrificial layer. A deposition technique, such as a partially ionized beam, can be used to deposit the aluminum and essentially fill the window. In one embodiment, the deposited metal should cover the exposed vertical surface of the dielectric layer and may cover portions of the exposed horizontal surfaces. At least portions of the surfaces of the sacrificial layer should be uncovered. The sacrificial layer, which typically compromises an inorganic dielectric such as a silicon oxide, together with the aluminum on the layer, is then removed. The top of the aluminum can thus form an essentially planar surface with the top surface of the dielectric.

In a preferred embodiment, a layer of protective material, such as amorphous silicon is deposited between the dielectric and sacrificial layers to protect the underlying dielectric layer and to assist in removing the sacrificial layer during lift off. The method is desirably practiced with windows, although openings in dielectrics on field oxides may be filled with metal to produce runners.

## Brief Description of the Drawing

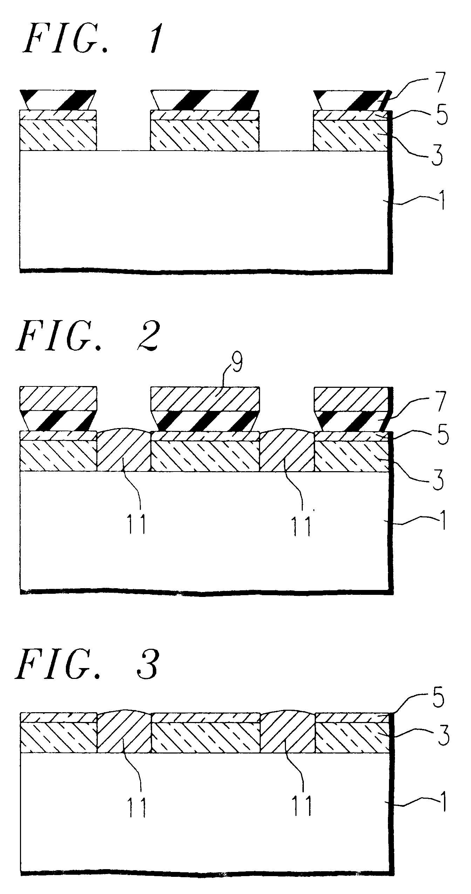

FIGs. 1-3 are sectional views useful in explaining the fabrication of integrated circuits according to this invention.

For reasons of clarity, the elements of the integrated circuit depicted are not drawn to scale. Identical numerals, when used in different FIGURES, represent identical elements.

## Detailed Description

FIG. 1 is a sectional view of an integrated circuit at an intermediate step of fabrication according to one embodiment of this invention. Depicted are substrate 1, dielectric layer 3, protective layer 5, and sacrificial layer 7. The term *substrate* is used to mean any material that lies underneath another material. The term substrate as used here thus includes the silicon wafer, a processed silicon wafer including, e.g., source and drain regions, as well as upper level metallizations, etc., depending upon the intermediate step. Elements of the integrated circuit not required for an explanation of this invention are not depicted for reasons of clarity. Those skilled in the art will readily appreciate that other elements, e.g., gate structures, source and drain regions, field oxides, etc., are present. The dielectric layer comprises any of the well-known dielectric materials used in semiconductor integrated circuit fabrication, including such inorganic dielectric materials as silicon dioxide, silicon nitride, etc. Silicon dioxide may typically have one or more dopants, such as boron or phosphorous, present. The protective layer comprises amorphous silicon in one embodiment and may be omitted in some embodiments. The protective layer should have a low etch rate with respect to the sacrificial dielectric layer. The sacrificial dielectric layer has a re-entrant angle and comprises a material that may be etched rapidly with respect to both the underlying material, i.e., the substrate, and the subsequently deposited metal, i.e., it has high etch selectivity. For example, a deposited oxide, such as TEOS, formed by the decomposition of a silicon and oxygen containing precursor gas, which is highly doped with at least one of boron, phosphorous and fluorine, is an expedient choice to use with the combination of silicon dioxide and aluminum. The reentrant angle facilitates the subsequent lift-off step. Formation of the re-entrant angle is facilitated by varying the doping concentrations, and thus the etch rates, with distance from the interface of layers 5 and 7. For example, fluorine can be used as a dopant with its concentration in the sacrificial layer decreasing as distance from the interface increases. This variation in doping concentration is desirable because the wet etch rate of the sacrificial layer in HF decreases as the dopant, e.g., fluorine, concentration decreases, thereby facilitating formation of the re-entrant angle. That is, the etch rate of the sacrificial dielectric layer should decrease as the distance from the underlying dielectric layer increases.

Except for the sacrificial layer, those skilled in the art will readily know how to fabricate the structure depicted. The dielectric will typically be a deposited dielectric although the use of grown oxides is also contemplated. A deposited oxide is typically formed by the decomposition of a silicon containing precursor gas. The gas precursor may contain oxygen or the oxygen may be separately supplied. The protective layer comprising amorphous silicon may be deposited in situ. Thicknesses for the layers depicted and sizes of windows will be readily selected after consideration of the devices being fabricated. The amorphous silicon layer may be 10 to 20nm thick.

The deposition of the sacrificial dielectric layer, as well as the steps which form the re-entrant angle in the sacrificial layer, deserve further comments. The dopants previously mentioned, if desired, will be readily included in the deposited layer. For example, the flow rates of the precursors of the dopants may be varied to obtain the desired variations in dopant concentrations. Appropriate dopant concentrations and variations can be easily determined. As previously mentioned, the sacrificial layer should etch more rapidly near the substrate than at the top of the layer. After conventional patterning of both dielectric layers and stripping of the photoresist, the re-entrant angles are formed by subjecting the sacrificial layer to a liquid etchant by, e.g., dipping briefly in HF acid.

FIG. 2 is a sectional view of the same portion of the integrated circuit depicted in FIG. 1 after metal deposition has been completed. The metal in the window is depicted as plug 11 and the metal on the sacrificial layer as layer 9. The deposition is continued until the opening is substantially filled with metal; i.e., the exposed vertical surfaces of the openings are covered. However, at least portions, and, desirably most, of the sidewalls of the sacrificial layer must be left exposed so that the sacrificial layer can be removed. A planar surface formed by the metal and dielectric layer can be obtained if metal deposition is terminated soon after the dielectric layer-protective layer interface is passed. An appropriate deposition technique for the metal will be readily selected by those skilled in the art, and partially ionized beam deposition, a well-known technique, is an exemplary metal deposition technique. This is a desirable deposition technique because it yields zero step coverage, i.e., there is a break in aluminum coverage of the sidewalls of the windows, and there is little or no overhang and therefore no shadowing. Good filling by metal near the walls of the window is achieved with an elevated temperature which enhances the mobility of the metal. The elevated temperature also improves sidewall adhesion. A temperature greater than 500°C is preferred for aluminum deposition. Of course, the sacrificial layer is chosen to withstand the elevated temperature.

The sacrificial layer is now removed and the unwanted metal thereby lifted off. The resulting structure is depicted in sectional view in FIG. 3. The removal technique used should have high horizontal versus vertical selectivity so that excessive amounts of neither the metal nor the dielectric are removed. That is, the sacrificial dielectric should be etched at a rate significantly higher than the rates for the dielectric and metal. Buffered 8:1 HF acid is an exemplary etchant. This etchant is desirable because it does not significantly attack either the metal (aluminum) or the amorphous silicon layer which protects the dielectric layer and therefore maintains its desired thickness. If a sufficiently high etch rate differential is obtained, the protective, i.e., amorphous silicon, layer may be omitted. If removal of the dielectric and metal occurs, the amount of metal deposited can be adjusted, within limits, to compensate for the etch rate differential. Thermal stress at the dielectric-sacrificial dielectric interface due to the high dopant concentration may also be used to promote mechanical delamination. Other etches will be readily thought of by those skilled in the art.

Variations in the embodiments described will be readily thought of by those skilled in the art. For example, the sacrificial dielectric layer might comprise doped amorphous silicon or silicon nitride. The sacrificial layer may have a constant chemical composition, but realize differential etching characteristics through density variations. Such variations may be obtained by varying the power used during the plasma deposition of the layer. For example, the re-entrant angles may be formed during the patterning step. Additionally, metal deposition may be continued so that the exposed horizontal surfaces of the protective or dielectric layer are covered. Other metal deposition techniques which also result in zero step coverage can be used to deposit the metal layer. Other techniques for forming re-entrant angles in the sacrificial dielectric layer may also be used. For example, the re-entrant angles may be formed during the patterning step. Additionally, dummy windows may be formed to aid the lift-off process. Other metals, such as copper, can be used.

## Claims

1. A method of semiconductor integrated circuit manufacturing comprising the steps of:
   forming a dielectric layer (3) on a substrate (1);
   depositing a sacrificial dielectric layer (7) on the first mentioned dielectric layer (3);
   patterning said sacrificial dielectric layer (7) and said first dielectric layer (3) to form openings which expose selected portions of said substrate (1);
   forming re-entrant angles in said sacrificial layer (7);
   depositing a metal (11) in said opening to substantially fill said openings;
   and removing said sacrificial dielectric layer (7) together with said metal (11) on said sacrificial dielectric layer (7).

2. A method as recited in claim 1 in which said sacrificial dielectric layer (7) comprises a silicon oxide with at least one dopant having a concentration which decreases as distance from said first dielectric layer (3) increases.

3. A method as recited in claim 1 comprising the further step of depositing a layer of protective mater (5) before depositing said sacrificial dielectric layer (7).

4. A method as recited in claim 3 in which said protective material (5) comprises amorphous silicon.

5. A method as recited in claim 1 in which said metal (11) comprises aluminum.

6. A method as recited in claim 5 in which said metal deposition is at a temperature of at least 500°C.

7. A method as recited in claim 1 in which said metal (11) comprises copper.

8. A method as recited in claim 1 in which said depositing a metal is by partially ionized beam deposition.

9. A method as recited in claim 1 in which said forming re-entrant angles comprises subjecting the sacrificial layer(7) to a liquid etchant.

FIG. 1

FIG. 2

FIG. 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | PATENT ABSTRACTS OF JAPAN vol. 5, no. 192 (E-85)(864) 8 December 1981 & JP-A-56 114 354 ( CHO LSI GIJUTSU KENKYU KUMIAI ) 8 September 1981 * abstract * | 1,5 | H01L21/90 H01L21/60 |
| Y | EP-A-0 057 738 (IBM) * page 6, line 32 - page 7, line 19; figures 6-9 * * page 11, line 21 - page 14, line 6 * | 1,3-9 | |
| Y | GB-A-2 226 446 (SAMSUNG) * page 9, line 10 - line 32; figures 1A-1C * | 1,3-9 | |
| Y,D | PROCEED. OF THE INT. IEEE  V-MIC CONF. 13 June 1988, pages 382 - 389; P. BAI ET AL: 'A simple technique for Al planarization' * page 382 - page 383 * | 6,8 | |
| Y | JAPANESE JOURNAL OF APPLIED PHYSICS. vol. 28, no. 10, October 1989, TOKYO JP pages 2193 - 2196; E. INAMURA ET AL: 'Wet chemical etching for ultrafine periodic structure: rectangular InP corrugations of 70 nm pitch and 100 nm depth' * abstract; figure 4 * | 9 | TECHNICAL FIELDS SEARCHED (Int. Cl.5 )  H01L |
| A | EP-A-0 309 274 (ATT) * abstract; figure 1 * | 3 | |

The present search report has been drawn up for all claims

| Place of search | Date of completion of the search | Examiner |
|---|---|---|
| BERLIN | 30 APRIL 1992 | ROUSSEL A.T. |